# EUROPÄISCHE PATENTANMELDUNG

(11) **EP 4 727 014 A1**
(43) Veröffentlichungstag der Anmeldung: **15.04.2026**
(21) Anmeldenummer: 25204198.3
(22) Anmeldetag: 24.09.2025
(51) Int. Cl.: H03K 17/96, F24C 7/08

(54) **BELEUCHTUNGSEINRICHTUNG FÜR EIN TASTENFELD**

(30) Priorität: 10.10.2024 DE 102024209872
(71) Anmelder: BSH Hausgeräte GmbH, 81739 München (DE)
(72) Erfinder: Schößner, Stephan, 93155 Hemau (DE); Ahmedov, Sezgin, 93073 Neutraubling (DE)

(57) **Zusammenfassung**

Ein Haushaltsgerät (100) umfasst zu seiner Steuerung ein Tastenfeld (105). Eine Beleuchtungseinrichtung (200) für ein solches Tastenfeld (105) umfasst eine lichtdurchlässige Deckscheibe (205), die sich in einer horizontalen Richtung erstreckt; eine Lichtquelle (225), die unter der Deckscheibe (205) angebracht ist; und einen Lichtkanal (220), der sich zwischen der Lichtquelle (225) und der Deckscheibe (205) erstreckt. Der Lichtkanal (220) weist eine erste (230) und eine zweite Reflexionsfläche (235) auf; wobei die erste Reflexionsfläche (230) parabolisch bezüglich einer vertikalen Leitlinie (250) und die zweite Reflexionsfläche (235) sphärisch geformt ist; und wobei die Lichtquelle (225) im Bereich eines Brennpunkts der Parabel angeordnet ist.

## Beschreibung

Die vorliegende Erfindung betrifft ein Haushaltsgerät mit einem Tastenfeld. Insbesondere betrifft die Erfindung eine Beleuchtungseinrichtung für ein solches Tastenfeld.

Ein Haushaltsgerät umfasst ein Tastenfeld, das dazu eingerichtet ist, durch einen Benutzer an verschiedenen Stellen berührt zu werden, um das Haushaltsgerät zu steuern. Am Tastenfeld können unterschiedliche Berührpunkte ausgebildet sein, die jeweils einer vorbestimmten Funktion des Haushaltsgeräts zugeordnet sind. Ein Berührpunkt kann von unterhalb des Tastenfelds beleuchtet werden, um dem Benutzer einen Hinweis zu geben, an welcher Stelle eine Funktion ausgelöst werden kann. Optional ist eine Maske vorgesehen, um von hinten durchtretendem Licht ein vorbestimmtes Muster aufzuprägen, insbesondere in Form eines Symbols, welches auf eine zugeordnete Funktion hinweist.

Es wurden verschiedene Vorschläge gemacht, um ein Bedienelement an einem Tastenfeld von hinten zu beleuchten. Allgemein problematisch ist hierbei, das Bedienelement mit geringem Aufwand so zu beleuchten, dass die Leuchtdichte im Bereich des Bedienelements möglichst konstant ist.

EP 2 463 155 A2 schlägt eine Beleuchtungseinrichtung mit zwei gekrümmten Reflexionsflächen vor. EP 2 924 486 B1 zeigt eine Variante einer Beleuchtungseinrichtung zum Einsatz an einem Fahrzeuginstrument. EP 2 657 083 betrifft eine Beleuchtungseinrichtung für eine Innenbeleuchtung eines Fahrzeugs und verwendet ebenfalls zwei gekrümmte Reflexionsflächen.

Eine der vorliegenden Erfindung zu Grunde liegende Aufgabe besteht in der Bereitstellung einer verbesserten Beleuchtungseinrichtung für ein Tastenfeld, insbesondere zur Steuerung eines Haushaltsgeräts. Die Erfindung löst diese Aufgabe mittels der Gegenstände der unabhängigen Ansprüche. Unteransprüche geben bevorzugte Ausführungsformen wieder.

Zur Steuerung eines Haushaltsgeräts ist ein Tastenfeld vorgesehen. Nach einem ersten Aspekt der vorliegenden Erfindung umfasst eine Beleuchtungseinrichtung für ein solches Tastenfeld eine lichtdurchlässige Deckscheibe, die sich in einer horizontalen Richtung erstreckt; eine Lichtquelle, die unter der Deckscheibe angebracht ist; und einen Lichtkanal, der sich zwischen der Lichtquelle und der Deckscheibe erstreckt. Der Lichtkanal weist eine erste und eine zweite Reflexionsfläche auf. Die erste Reflexionsfläche ist parabolisch bezüglich einer vertikalen Leitlinie geformt, wobei die Lichtquelle im Bereich eines Brennpunkts der Parabel angeordnet ist. Die zweite Reflexionsfläche ist hingegen sphärisch geformt.

Die erste und die zweite Reflexionsfläche sind bevorzugt derart arrangiert, dass Licht aus der Lichtquelle zunächst an der ersten und dann an der zweiten Reflexionsfläche reflektiert wird, bevor es auf die Deckscheibe trifft. Dabei wird das Licht an der ersten Reflexionsfläche im Wesentlichen in horizontaler Richtung abgelenkt, um auf die zweite Reflexionsfläche zu treffen. Die zweite Reflexionsfläche kann das Licht vorteilhaft homogen in Richtung der Deckscheibe reflektieren.

Durch die beschriebene Geometrie der Beleuchtungseinrichtung kann auf zusätzliche Maßnahmen zur Streuung oder Homogenisierung von Licht im Bereich des Lichtkanals, beispielsweise durch eine Einlage aus einem Kunststoff wie Epoxidharz, verzichtet werden. Eine Herstellung und/oder Montage der Beleuchtungseinrichtung können dadurch vereinfacht sein. Von der Lichtquelle ausgesandtes Licht kann an der Deckscheibe verbessert homogen und mit verbesserter Lichtausbeute eintreffen. Für das menschliche Auge kann das Licht an der Deckscheibe frei von hellen oder dunklen Flecken sein.

Die beschriebene Geometrie ist mit Bezug auf eine horizontale Orientierung der Deckscheibe beschrieben. Selbstverständlich kann ein Tastenfeld mit der Beleuchtungseinrichtung auch in einer beliebigen anderen Richtung orientiert sein. Formen der Reflexionsflächen sind mit Bezug auf eine vertikale Schnittebene durch die Lichtquelle beschrieben. In dieser Schnittebene ist die Form der zweiten Reflexionsfläche bevorzugt kreisförmig. Die erste Reflexionsfläche kann hingegen die Form eines Parabelasts aufweisen. In einer Richtung senkrecht zur Schnittebene können sich die Reflexionsflächen in gerader Richtung erstrecken.

Die Lichtquelle kann an einer ebenen Fläche angebracht sein, die sich parallel zur Deckscheibe erstreckt. Der Lichtkanal liegt dabei zwischen der ebenen Fläche und der Deckscheibe. Die ebene Fläche kann eine Leiterplatte (Printed Circuit Board, PCB) begrenzen, die sich ebenfalls parallel zur Deckscheibe erstreckt. Die Oberfläche der ebenen Fläche kann eine hoch reflektierende Beschichtung aufweisen um die Absorption des Lichtes an dieser Fläche zu minimieren. Eine solche Beschichtung der Leiterplatte ist als Silk Screen bekannt und kann beispielsweise in weißer, bevorzugt glänzender Farbe vorgesehen sein. Die Beleuchtungseinrichtung kann in Sandwich-Technik zusammen mit der Deckscheibe und der Leiterplatte aufgebaut sein. So kann eine separat handhabbare Einheit geschaffen sein, die von einem Tastenfeld umfasst sein kann. Eine auf der Oberfläche der Leiterplatte angebrachte Lichtquelle kann ausreichend genau im Brennpunkt der Parabel liegen, um die beschriebene Funktion der Beleuchtungseinrichtung zu ermöglichen. Die Lichtquelle kann im Bereich des Brennpunkts liegen, wenn ihr Mittelpunkt nicht mehr als ca. 1-2 ihrer Durchmesser vom Brennpunkt abweicht.

Die zweite Reflexionsfläche erstreckt sich bevorzugt in einem Winkel um einen Mittelpunkt, bis die gedachte Linie vom Mittelpunkt bis zum oberen Ende der zweiten Reflexionsfläche senkrecht auf der Reflexionsfläche des trichterförmigen Abschnitts steht. In der beschriebenen Schnittebene kann die zweite Reflexionsfläche ein Kreissegment bilden. Ein Mittelpunktswinkel des Kreissegments kann ca. 90° betragen. Die Deckscheibe kann so in einem vorbestimmten Bereich besonders homogen ausgeleuchtet werden. Der vorbestimmte Bereich kann in etwa die Fläche einer Fingerkuppe aufweisen und dazu eingerichtet sein, durch eine Bedienperson betätigt zu werden. Die Betätigung kann beispielsweise mittels eines kapazitiven Näherungssensors erfasst werden. Optional ist an der Deckscheibe eine Maske, eine Blende oder ein teiltransparenter Film vorgesehen, um an der Oberseite der Deckscheibe ein beleuchtetes Symbol darzustellen, welches der Benutzer mit einem Finger berühren kann.

Es ist weiter bevorzugt, dass der Mittelpunkt des Kreises, der die zweite Reflexionsfläche definiert, nahe oder an der ersten Reflexionsfläche liegt. Insbesondere kann der Mittelpunkt an einem Ende der parabolischen ersten Reflexionsfläche liegen. Der Mittelpunkt kann auch etwas entfernt von der ersten Reflexionsfläche liegen. Ein von der ersten Reflexionsfläche umschlossener Raum kann dadurch unmittelbar an einen von der zweiten Reflexionsfläche umschlossenen Raum angrenzen. Eine Trennfläche zwischen den beiden Räumen steht bevorzugt senkrecht auf der Deckscheibe bzw. der Leiterplatte und damit parallel zur vertikalen Leitlinie.

Weiter bevorzugt nehmen die erste und die zweite Reflexionsfläche im Wesentlichen dieselbe vertikale Höhe ein. In einer Weiterführung des Gedankens kann zwischen den Reflexionsflächen und der Deckscheibe ein vorbestimmter Abstand bestehen. In einer Ausführungsform liegt in diesem Abstand ein trichterförmiger Abschnitt, der sich in Richtung der Deckscheibe öffnet. Bevorzugt ist der Trichter symmetrisch ausgeführt und umfasst zwei weitere Reflexionsflächen, die einen Winkel gleicher Größe mit der unteren Oberfläche der Deckscheibe einschließen. Die weiteren Reflexionsflächen können den trichterförmigen Abschnitt seitlich begrenzen.

Bevorzugt sind die erste und die zweite Reflexionsfläche an einem gemeinsamen Abstandselement ausgebildet. Das Abstandselement liegt bevorzugt an der Deckscheibe an und weist eine im Wesentlichen konstante Schichtdicke auf. Weiter bevorzugt kann eine Leiterplatte, an welcher die Lichtquelle angebracht ist, an einer gegenüberliegenden Oberfläche des Abstandselements anliegen. Das Abstandselement umfasst eine Ausnehmung zwischen seiner Unterseite und seiner Oberseite, welche den Lichtkanal bildet. Eine Oberfläche des Abstandselements kann hochreflektierend sein. Optional kann eine Oberfläche mit einem reflektierenden Material, beispielsweise Metall, bedampft sein.

Das Abstandselement kann beispielsweise aus einem Kunststoff herstellbar sein, insbesondere mittels Spritzgießen. In einer weiter bevorzugten Ausführungsform sind die erste und die zweite Reflexionsfläche in horizontaler Richtung überlappungsfrei. Das Abstandselement kann vorteilhaft in einem zweiteiligen Werkzeug im Spritzguss-Verfahren hergestellt werden. Ein Teil des Werkzeugs füllt dabei den Raum aus, der von unten an die erste Reflexionsfläche angrenzt, und das andere Teil den Raum, der von oben an die zweite Reflexionsfläche angrenzt. Die Teile können entlang einer horizontalen Trennebene voneinander getrennt werden. Das Abstandselement kann dadurch kostengünstig auch in hohen Auflagen hergestellt werden.

Die Lichtquelle ist bevorzugt zumindest annähernd punktförmig, beispielsweise mit einem Durchmesser im Bereich von ca. 1-2 mm. Die Lichtquelle kann eine Leuchtdiode (Light Emitting Diode, LED) umfassen. Die Leuchtdiode kann eine im Wesentlichen punktförmige Lichtquelle darstellen, deren emittiertes Licht aus dem Bereich des Brennpunkts der Parabel heraus in guter Qualität auf ein Bedienelement an der Deckscheibe geworfen werden kann. Als Durchmesser der Lichtquelle kann bei der LED der Durchmesser eines umfassten Leuchtkristalls angesetzt werden.

Die Leuchtdiode kann mehrere Leuchtkristalle umfassen, die dazu eingerichtet sind, Licht in unterschiedlichen Farben bereitzustellen. Insbesondere können die Leuchtkristalle rotes, grünes und blaues Licht emittieren, die zu optisch weißem Licht gemischt werden können. Durch einen technisch bedingten Versatz der Leuchtkristalle gegeneinander kann in einer optischen Anordnung leicht ein Farbquerfehler entstehen, der unterschiedlich farbiges Licht insbesondere in einem Randbereich einer Projektion umfasst. Durch die beschriebene Anordnung kann ein solcher Fehler weitgehend vermieden werden. Ein Bedienelement an der Deckscheibe kann im Wesentlichen homogen und in beliebigen Farben beleuchtet werden. Als Durchmesser der Lichtquelle kann in diesem Fall der Durchmesser eines kleinsten geometrischen Körpers verwendet werden, der alle Leuchtkristalle umschließt, beispielsweise eine Sphäre oder ein Quader.

Nach einem weiteren Aspekt der vorliegenden Erfindung umfasst ein Tastenfeld eine hierin beschriebene Beleuchtungseinrichtung. Das Tastenfeld kann auch mehrere Beleuchtungseinrichtungen umfassen, die entlang einer geraden Linie angeordnet sind. Die parabelförmige und die kreisförmige Reflexionsfläche können dabei entlang der Richtung, in der die Beleuchtungseinrichtungen nebeneinander liegen, gerade ausgeführt sein. Die Reflexionsflächen können dadurch jeweils die Form einer Rinne aufweisen.

Das Tastenfeld kann zusätzlich eine Abtasteinrichtung umfassen, mit der eine Berührung der Deckscheibe im Bereich einer Beleuchtungseinrichtung erfasst werden kann. Außerdem kann eine Maske oder ein Filter vorgesehen sein, um im Bereich einer Beleuchtungseinrichtung durchtretendes Licht passend zu prägen.

Nach wieder einem weiteren Aspekt der vorliegenden Erfindung umfasst ein Haushaltsgerät ein hierin beschriebenes Tastenfeld. Das Haushaltsgerät umfasst bevorzugt ein Küchengerät, beispielsweise einen Herd, einen Backofen, einen Dampfgarer, eine Dunstabzugshaube, einen Kühlschrank, einen Geschirrspüler oder ein ähnliches Gerät. In einer anderen Variante ist das Haushaltsgerät zur Wäschepflege eingerichtet und umfasst beispielsweise eine Waschmaschine, einen Wäschetrockner, eine Bügelstation oder ein Bügeleisen. Andere Haushaltsgeräte sind ebenfalls möglich.

Die Verarbeitungseinrichtung kann dazu eingerichtet sein, ein hierin beschriebenes Verfahren teilweise oder vollständig auszuführen. Dazu kann die Verarbeitungseinrichtung elektronisch ausgeführt sein und beispielsweise einen programmierbaren Mikrocomputer oder Mikrocontroller umfassen. Das Verfahren kann in Form eines Computerprogrammprodukts mit Programmcodemitteln vorliegen. Das Computerprogrammprodukt kann auch auf einem computerlesbaren Datenträger abgespeichert sein. Merkmale oder Vorteile des Verfahrens können auf die Vorrichtung übertragen werden und umgekehrt.

Nicht beschränkende Ausführungsformen der Erfindung werden nun unter Bezug auf die beiliegenden Figuren genauer beschrieben, in denen:
- Figur 1: ein Haushaltsgerät mit einem Tastenfeld; und
- Figur 2: eine Beleuchtungseinrichtung für ein Bedienelement darstellen.

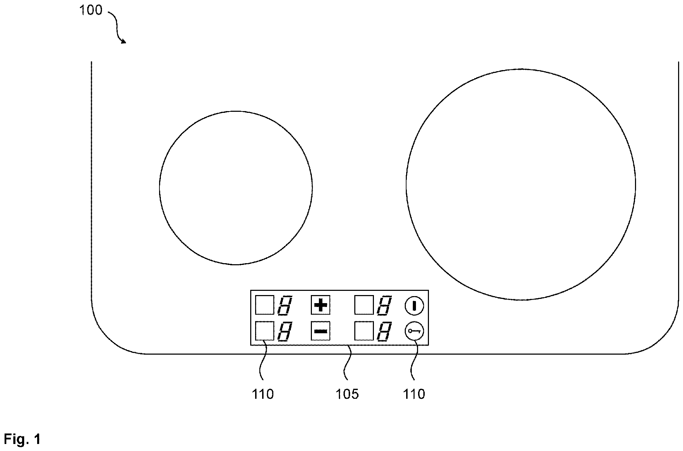

Figur 1 zeigt ein Haushaltsgerät 100 mit einem Tastenfeld 105. Rein beispielhaft umfasst das Haushaltsgerät 100 ein Kochfeld, von dem in der Draufsicht nur ein Abschnitt dargestellt ist. Das Tastenfeld 105 ist als beispielhaft zu verstehen und umfasst eines oder mehrere Bedienelemente 110 zur Steuerung des Haushaltsgeräts 100. Ein Bedienelement 110 kann durch einen Benutzer mit dem Finger berührt werden, um eine zugeordnete Funktion des Haushaltsgeräts 100 zu steuern. Um kenntlich zu machen, an welcher Stelle das Tastenfeld 105 berührt werden kann und welche Funktion dadurch gesteuert wird, kann ein Bedienelement 110 von hinten beleuchtet sein. Die Beleuchtung kann durch eine Maske oder einen Film fallen, sodass sich einem Benutzer ein Symbol oder eine Darstellung, auch mehrfarbig, darbietet.

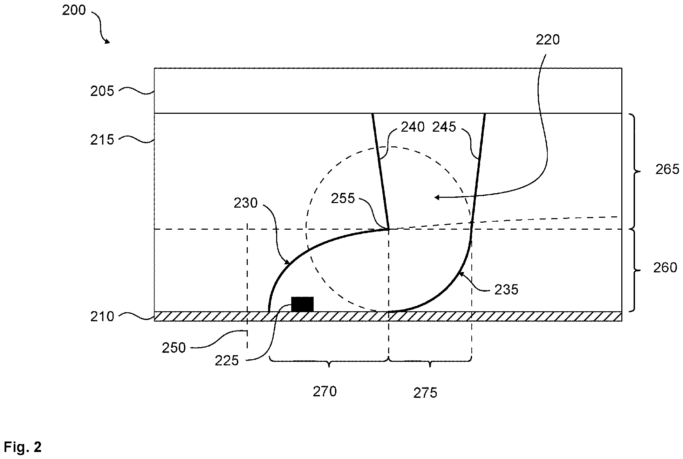

Figur 2 zeigt eine Beleuchtungseinrichtung 200 für ein Bedienelement 110, insbesondere in einem Tastenfeld 105. Die Beleuchtungseinrichtung 200 umfasst eine Deckscheibe 205, eine Leiterplatte 210 und ein dazwischenliegendes Abstandselement 215. Die Deckscheibe 205 ist dazu eingerichtet, an ihrer Oberseite durch einen Benutzer berührt zu werden. Die Darstellung von Figur 2 zeigt einen vertikalen Längsschnitt, der senkrecht durch die Deckscheibe 205 verläuft. Allgemein gilt, dass sich die Deckscheibe 205, die Leiterplatte 210 und das Abstandselement 215 in einer Richtung senkrecht zur Betrachtungsebene in gerader Richtung beliebig lange fortsetzen können.

Das Abstandselement 215 weist eine Aussparung auf, die als Lichtkanal 220 dient. Der Lichtkanal 220 grenzt unten an die Leiterplatte 210 und oben an die Deckscheibe 205 an.

An der Leiterplatte 210 ist eine Lichtquelle 225 angebracht, die bevorzugt als Leuchtdiode ausgeführt ist. Insbesondere kann die Lichtquelle 225 an einer Oberfläche der Leiterplatte 210 montiert sein und liegt im Lichtkanal 220.

Der Lichtkanal 220 ist begrenzt durch eine erste Reflexionsfläche 230 und eine zweite Reflexionsfläche 235. In der dargestellten Ausführungsform sind außerdem eine dritte und eine vierte Reflexionsfläche 240, 245 vorgesehen.

Die erste Reflexionsfläche 230 hat die Form eines Abschnitts eines Parabelasts. Die Lichtquelle 225 liegt bevorzugt in einem Brennpunkt der zugehörigen Parabel. Es hat sich gezeigt, dass eine leichte Abweichung der Position der Lichtquelle 225 vom Brennpunkt tolerierbar ist. Die Parabel ist bezüglich einer Leitlinie 250 definiert, die sich in vertikaler Richtung, also senkrecht zur Deckscheibe 205, erstreckt. Die Parabel ist dabei gegeben als der geometrische Ort aller Punkte, deren Abstand zum Brennpunkt gleich dem Abstand zur Leitlinie 250 ist. Licht, das vom Brennpunkt aus auf die erste Reflexionsfläche 230 trifft, wird in der Ausführungsform von Figur 2 horizontal nach rechts reflektiert.

Die zweite Reflexionsfläche 235 folgt einer Kreislinie um einen Mittelpunkt 255. Dabei deckt die zweite Reflexionsfläche 235 bevorzugt einen Mittelpunktswinkel ab, bis die gedachte Linie vom Mittelpunkt 255 bis zum oberen Ende der zweiten Reflexionsfläche 235 senkrecht auf der dritten Reflexionsfläche 245 des trichterförmigen Abschnitts steht. Anders ausgedrückt beschreibt die zweite Reflexionsfläche 235 bevorzugt im Wesentlichen ein Kreissegment. Die zweite Reflexionsfläche 235 geht bevorzugt fließend bzw. knickfrei in die dritte Reflexionsfläche 245 über. Die Größe des Mittelpunktswinkels des Kreissegments kann also davon abhängen, wie stark die dritte Reflexionsfläche 245 gegenüber der Horizontalen geneigt ist.

Der Mittelpunkt 255 kann auf der Parabel bzw. dem Parabelast liegen, welcher die erste Reflexionsfläche 230 definiert. In einer Ausführungsform liegt der Mittelpunkt 255 an einem rechten Ende der ersten Reflexionsfläche 230. In einer anderen Ausführungsform liegt der Mittelpunkt 255 etwas von dem Parabelast entfernt, beispielsweise um wenige Millimeter oder um bis zu ca. 1-2 Durchmesser der Lichtquelle 255. Bezüglich der gewählten Richtungen weisen die erste Reflexionsfläche 230 und die zweite Reflexionsfläche 235 weiter bevorzugt dieselbe erste Höhe 260 auf.

Oberhalb des Mittelpunkts 255 kann sich der Lichtkanal 220 über eine zweite Höhe 265 fortsetzen, bevor er auf die Deckscheibe 205 trifft. In diesem Bereich ist der Lichtkanal 220 bevorzugt trichterförmig mit geraden Seiten, die symmetrisch auseinanderlaufen. Diese Seiten entsprechen in Figur 1 der dritten Reflexionsfläche 240 bzw. vierten Reflexionsfläche 245.

In horizontaler Richtung nimmt die erste Reflexionsfläche 230 eine erste Breite 270 und die zweite Reflexionsfläche 235 eine daran anschließende zweite Breite 275 ein. Das Abstandselement 215 kann beispielsweise im Spritzguss-Verfahren hergestellt werden, wobei ein zweiteiliges Werkzeug verwendet werden kann, dessen erstes Teil die Unterseite und die erste Reflexionsfläche 230, und dessen zweites Teil die Oberseite und die Reflexionsflächen 235 bis 245 des Abstandselements 215 definiert. Bei zusammengefügtem, d. h. geschlossenem Werkzeug liegen die beiden Teile an einer vertikalen Fläche aneinander, welche die erste Höhe 260 zwischen den Breiten 270 und 275 überspannt. Nach erfolgtem Spritzguss kann das erste Teil nach unten und das zweite nach oben bewegt werden, um das Abstandselement 215 freizugeben.

Das Abstandselement 215 ist bevorzugt aus einem Kunststoff gefertigt, dessen Oberfläche hochgradig reflektierend ist. Falls erforderlich, kann eine Reflexionsfläche 230 bis 245 nachbearbeitet werden. Die Nachbearbeitung kann insbesondere eine Beschichtung mit einem noch stärker reflektierenden Material und/oder ein Polieren umfassen.

Es ist zu beachten, dass ein Bedienelement 110 außer der in Figur 2 dargestellten Beleuchtungseinrichtung 200 noch weitere Elementen umfassen kann, die hier nicht dargestellt sind. Solche dargestellte Elemente insbesondere eine Ansteuerung der Lichtquelle 225 umfassen, ferner eine optionale Maske oder Folie, insbesondere in einem Bereich, wo der Lichtkanal 220 auf die Deckscheibe 205 trifft, oder eine Elektrode in diesem Bereich, um eine Berührung der Deckscheibe 205 durch einen Benutzer zu erfassen. Eine Ansteuerschaltung, um mittels der Elektrode eine Annäherung eines Benutzers kapazitiv zu bestimmen, ist ebenfalls nicht dargestellt.

### Bezugszeichen

- 100: Haushaltsgerät
- 105: Tastenfeld
- 110: Bedienelement

- 200: Beleuchtungseinrichtung
- 205: Deckscheibe
- 210: Leiterplatte
- 215: Abstandselement
- 220: Lichtkanal
- 225: Lichtquelle

- 230: erste Reflexionsfläche
- 235: zweite Reflexionsfläche
- 240: dritte Reflexionsfläche
- 245: vierte Reflexionsfläche

- 250: Leitlinie
- 255: Mittelpunkt
- 260: erste Höhe
- 265: zweite Höhe

- 270: erste Breite
- 275: zweite Breite

## Patentansprüche

1. Beleuchtungseinrichtung (200) für ein Tastenfeld (105) zur Steuerung eines Haushaltsgeräts (100), wobei die Beleuchtungseinrichtung (200) folgende Elemente umfasst:
- eine lichtdurchlässige Deckscheibe (205), die sich in einer horizontalen Richtung erstreckt;
- eine Lichtquelle (225), die unter der Deckscheibe (205) angebracht ist;
- einen Lichtkanal (220), der sich zwischen der Lichtquelle (225) und der Deckscheibe (205) erstreckt;
- wobei der Lichtkanal (220) eine erste (230) und eine zweite Reflexionsfläche (235) aufweist;
- wobei die erste Reflexionsfläche (230) parabolisch bezüglich einer vertikalen Leitlinie (250) geformt ist;
- wobei die Lichtquelle (225) im Bereich eines Brennpunkts der Parabel angeordnet ist;
- wobei die zweite Reflexionsfläche (235) sphärisch geformt ist.

2. Beleuchtungseinrichtung (200) nach Anspruch 1, wobei die Lichtquelle (225) an einer ebenen Fläche (210) angebracht ist, die sich parallel zur Deckscheibe (205) erstreckt.

3. Beleuchtungseinrichtung (200) nach einem der vorangehenden Ansprüche, wobei sich die zweite Reflexionsfläche (235) in einem Winkel von ca. 90° um einen Mittelpunkt (255) erstreckt.

4. Beleuchtungseinrichtung (200) nach Anspruch 3, wobei der Mittelpunkt (255) an der ersten Reflexionsfläche (230) liegt.

5. Beleuchtungseinrichtung (200) nach einem der vorangehenden Ansprüche, wobei die erste (230) und die zweite Reflexionsfläche (235) im Wesentlichen dieselbe vertikale Höhe (260) einnehmen.

6. Beleuchtungseinrichtung (200) nach Anspruch 5, wobei zwischen den Reflexionsflächen (230, 235) und der Deckscheibe (205) ein in vertikaler Richtung trichterförmiger Abschnitt liegt.

7. Beleuchtungseinrichtung (200) nach Anspruch 6, wobei der Abschnitt seitlich durch weitere Reflexionsflächen (240, 245) begrenzt ist.

8. Beleuchtungseinrichtung (200) nach einem der vorangehenden Ansprüche, wobei die erste (230) und die zweite Reflexionsfläche (235) an einem gemeinsamen Abstandselement (215) ausgebildet sind.

9. Beleuchtungseinrichtung (200) nach Anspruch 8, wobei die erste (230) und die zweite Reflexionsfläche (235) in horizontaler Richtung überlappungsfrei sind.

10. Beleuchtungseinrichtung (200) nach einem der vorangehenden Ansprüche, wobei die Lichtquelle (225) eine Leuchtdiode umfasst.

11. Beleuchtungseinrichtung (200) nach Anspruch 10, wobei die Leuchtdiode mehrere Leuchtkristalle umfasst, die dazu eingerichtet sind, Licht in unterschiedlichen Farben bereitzustellen.

12. Tastenfeld (105), umfassend eine Beleuchtungseinrichtung (200) nach einem der vorangehenden Ansprüche.

13. Haushaltsgerät (100), umfassend ein Tastenfeld (105) nach Anspruch 12.
